# EUROPEAN PATENT APPLICATION

(11) **EP 4 571 855 A1**
(43) Date of publication of application: **18.06.2025**
(21) Application number: 23852447.4
(22) Date of filing: 01.08.2023
(51) Int. Cl.: H01L 33/30, H01S 5/323

(54) **METHOD FOR PRODUCING BONDED WAFER FOR MICRO LEDS**

(30) Priority: 10.08.2022 JP 2022128478
(71) Applicant: Shin-Etsu Handotai Co., Ltd., Tokyo 100-0004 (JP); SHIN-ETSU CHEMICAL CO., LTD., Tokyo 1000005 (JP); TSLC Corporation, Miao-Li County, 350 (TW)
(72) Inventor: ISHIZAKI, Junya, Annaka-shi, Gunma 379-0196 (JP); AKIYAMA, Tomohiro, Annaka-shi, Gunma 379-0196 (JP); OGAWA, Yoshinori, Tokyo 100-0005 (JP); CHU, Chen-Fu, Hsinchu City 300 (TW); CHAN, Shih-Kai, Miaoli County 350 (TW); SHIH, Yi-Feng, Toufen City, Miaoli County 351 (TW)
(74) Representative: Röthinger, Rainer
(86) International application number: PCT/JP2023/028189
(87) International publication number: WO 2024/034480

(57) **Abstract**

The present invention is a method for manufacturing a bonded wafer for a micro-LED, the method includes the steps of epitaxially growing an AlGaInP-based first cladding layer, non-doped active layer, and second cladding layer on a GaAs substrate to form an epitaxial layer, growing a GaP window layer on the second cladding layer, bonding the GaP window layer to a transparent substrate via a thermosetting bonding member, separating the GaAs substrate, isolating the epitaxial layer into micro-LED devices, exposing the second cladding layer or the GaP window layer of the micro-LED device, forming electrodes, adhering the electrodes to a transfer substrate, and irradiating a laser from the transparent substrate side to isolate the micro-LED device from the transparent substrate, in which the GaP window layer has a thickness of 6 µm or more. This provides a method for manufacturing a bonded wafer for an AlGaInP-based micro-LED which improves a yield decrease caused by a crack in a micro-LED device during a LLO step.

## Description

### TECHNICAL FIELD

The present invention relates to a method for manufacturing a bonded wafer for a micro-LED.

### BACKGROUND ART

An art to realize displays using micro light emitting diodes (micro-LEDs) is disclosed (Patent Document 1), where GaN-based LEDs are separated from starting substrates using a laser lift-off (LLO) technique and the LEDs are transferred to a mounting substrate, followed by transfer to a drive substrate.

While an art compatible with the LLO of LEDs where two electrodes are provided on an upper surface thereon has been disclosed (Patent Document 2), this disclosure pertains to GaN-based LEDs and a configuration thereof is a very typical film thickness structure. This is because a mechanical strength of the GaN-based LED is strong, resulting in few structural requirements for the LLO transferring process conditions.

On the other hand, no art of LLO using AlGaInP-based LED has been disclosed. A starting substrate of the AlGaInP-based LED is made of GaAs, and the LLO is theoretically impossible with the starting substrate being still attached. However, when the starting substrate is removed and an epitaxial layer is transferred to a substrate capable of the LLO, it is possible to enable performing the LLO.

While the art of LLO is not applied, as an art for transferring the AlGaInP-based LEDs by etching a sacrificial layer to separate the LEDs from a starting substrate is disclosed (Patent Document 3). Moreover, an art of removing a sacrificial layer and then bonding the LEDs to a support substrate via BCB (adhesive) is disclosed (Patent Document 4) but a structure thereof is not compatible with LLO, and an AlGaInP-based LED structure suitable for the LLO has not been disclosed.

The AlGaInP-based LEDs have lower mechanical strength compared to the GaN-based LEDs. Therefore, when performing LLO transfer with the AlGaInP-based LEDs having a structure where two electrodes are on the upper surface, a transfer step has a problem in which the LEDs are cracked (destroyed) under the same conditions as in the GaN-based LEDs.

### CITATION LIST

### PATENT LITERATURE

Patent Document 1: JP 2020-521181 A
Patent Document 2: JP 2015-2324 A
Patent Document 3: JP 2021-153186 A
Patent Document 4: JP 2006-32952 A

### SUMMARY OF INVENTION

### TECHNICAL PROBLEM

The present invention has been made in view of the above-described problem. An object of the present invention is to provide a method for manufacturing a bonded wafer for an AlGaInP-based micro-LED, in which a yield decrease due to a micro-LED cracking during an LLO step is improved.

### SOLUTION TO PROBLEM

To achieve the object, the present invention provides a method for manufacturing a bonded wafer for a micro-LED, the method comprising the steps of:
epitaxially growing an AlGaInP-based first cladding layer having a first conductivity-type, an AlGaInP-based non-doped active layer, and an AlGaInP-based second cladding layer having a second conductivity-type on a GaAs substrate to form an epitaxial layer;
growing a GaP window layer on the second cladding layer;
bonding the GaP window layer to a transparent substrate, being a to-be-bonded substrate transparent to visible light and ultraviolet light, via a thermosetting bonding member;
separating the GaAs substrate;
isolating the epitaxial layer into micro-LED devices each having a quadrilateral shape with a short side length of 50 µm or less;
exposing the second cladding layer or the GaP window layer in a partial region of the micro-LED device;
forming a first electrode in contact with a layer having the first conductivity-type and a second electrode in contact with a layer having the second conductivity-type, and performing heat treatment to form an ohmic contact;
adhering the first electrode and the second electrode to a transfer substrate via silicone resin; and
irradiating a laser from the transparent substrate side and sublimating the thermosetting bonding member in contact with the transparent substrate through laser lift-off treatment to isolate the micro-LED device from the transparent substrate, wherein
the GaP window layer has a thickness of 6 µm or more.

In this way, by making a thickness of the GaP window layer 6 µm or more, even a minute AlGaInP-based micro-LED device having a quadrilateral shape with a short side length of 50 µm or less can suppress cracking during laser lift-off treatment and improve a yield decrease.

In this case, the thermosetting bonding member is preferably at least any of benzocyclobutene, silicone resin, epoxy resin, SOG, polyimide, and amorphous fluororesin.

With such a thermosetting bonding member, it is possible to reliably perform laser lift-off treatment using an excimer laser.

In addition, the transparent substrate is preferably a sapphire substrate or a quartz substrate.

When the transparent substrate, being the to-be-bonded substrate, is made of sapphire or quartz, this substrate is transparent to the excimer laser, has sufficient thermal strength, and is therefore suitable.

Moreover, it is preferable that a method in the step of isolating the epitaxial layer into the micro-LED devices involves forming a pattern by a photolithography method, followed by an ICP etching using chlorine gas and argon gas.

According to such a method, device isolation can be achieved relatively easily and reliably.

In addition, the transfer substrate is preferably a quartz substrate.

In the inventive method for manufacturing a bonded wafer for a micro-LED, the quartz substrate can be suitably used as the transfer substrate.

### ADVANTAGEOUS EFFECTS OF INVENTION

A method for manufacturing a bonded light-emitting device wafer according to the present invention can be applied to a method for manufacturing a bonded wafer for an AlGaInP-based micro-LED. In this method, even when producing a minute micro-LED device having a quadrilateral shape with a short side length of 50 µm or less with an AlGaInP-based material which is a material having relatively low strength, the yield decrease caused by the crack of the micro-LED device during the laser lift-off step can be improved by making the GaP window layer as a thick layer having a thickness of 6 µm or more.

### BRIEF DESCRIPTION OF DRAWINGS

FIG. 1 is a schematic cross-sectional view illustrating a part of a method for manufacturing a bonded wafer for a micro-LED according to the present invention.
FIG. 2 is a schematic cross-sectional view illustrating another part of a method for manufacturing a bonded wafer for a micro-LED according to the present invention.
FIG. 3 is a schematic cross-sectional view illustrating another part of a method for manufacturing a bonded wafer for a micro-LED according to the present invention.
FIG. 4 is a schematic cross-sectional view illustrating another part of a method for manufacturing a bonded wafer for a micro-LED according to the present invention.
FIG. 5 is a schematic cross-sectional view illustrating another part of a method for manufacturing a bonded wafer for a micro-LED according to the present invention.
FIG. 6 is a schematic cross-sectional view illustrating another part of a method for manufacturing a bonded wafer for a micro-LED according to the present invention.
FIG. 7 is a schematic cross-sectional view illustrating another part of a method for manufacturing a bonded wafer for a micro-LED according to the present invention.
FIG. 8 is a schematic cross-sectional view illustrating another part of a method for manufacturing a bonded wafer for a micro-LED according to the present invention.
FIG. 9 is a schematic cross-sectional view illustrating another part of a method for manufacturing a bonded wafer for a micro-LED according to the present invention.
FIG. 10 is a schematic cross-sectional view illustrating another part of a method for manufacturing a bonded wafer for a micro-LED according to the present invention.
FIG. 11 is a graph illustrating yield results for each wafer having different GaP window layer thicknesses of bonded wafers for micro-LEDs manufactured in Example and Comparative Example.

### DESCRIPTION OF EMBODIMENTS

Hereinafter, the present invention will be described in detail. However, the present invention is not limited thereto.

The present invention is a method for manufacturing a bonded wafer for a micro-LED, the method comprising the steps of:
epitaxially growing an AlGaInP-based first cladding layer having a first conductivity-type, an AlGaInP-based non-doped active layer, and an AlGaInP-based second cladding layer having a second conductivity-type on a GaAs substrate to form an epitaxial layer;
growing a GaP window layer on the second cladding layer;
bonding the GaP window layer to a transparent substrate, being a to-be-bonded substrate transparent to visible light and ultraviolet light, via a thermosetting bonding member;
separating the GaAs substrate;
isolating the epitaxial layer into micro-LED devices each having a quadrilateral shape with a short side length of 50 µm or less;
exposing the second cladding layer or the GaP window layer in a partial region of the micro-LED device;
forming a first electrode in contact with a layer having the first conductivity-type and a second electrode in contact with a layer having the second conductivity-type, and performing heat treatment to form an ohmic contact;
adhering the first electrode and the second electrode to a transfer substrate via silicone resin; and
irradiating a laser from the transparent substrate side and sublimating the thermosetting bonding member in contact with the transparent substrate through laser lift-off treatment to isolate the micro-LED device from the transparent substrate, wherein
the GaP window layer has a thickness of 6 µm or more.

Hereinafter, the aspects of the present invention will be described, referring to the drawings.

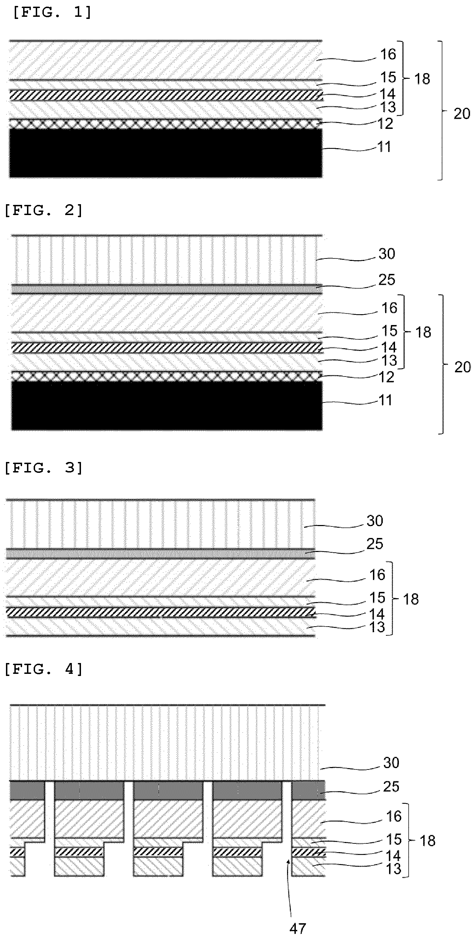

First, an AlGaInP-based light-emitting device structure is formed on a GaAs substrate. Accordingly, as shown in FIG. 1, an AlGaInP-based first cladding layer 13 having a first conductivity-type, an AlGaInP-based non-doped active layer 14, and an AlGaInP-based second cladding layer 15 having a second conductivity-type are epitaxially grown in sequence on a GaAs substrate 11, being a starting substrate, to form an epitaxial layer. Meanwhile, a GaP window layer 16 is grown on the second cladding layer 15. In this way, each layer is formed to produce an epitaxial wafer 20. More specifically, each layer can be epitaxially grown in the following manner.

As shown in FIG. 1, an etching stop layer 12 is epitaxially grown on the first conductivity-type GaAs substrate 11, being the starting substrate. The etching stop layer 12 can be formed, for example, after laminating a first conductivity-type GaAs buffer layer, followed by growing a first conductivity-type GaₓIn₁₋ₓP (0.4≤x≤0.6) first etching stop layer of, e.g., 0.1 µm, and a first conductivity-type GaAs second etching stop layer of, e.g., 0.1 µm. Moreover, the epitaxial wafer 20 is provided with a light-emitting device structure 18 as an epitaxial functional layer, in which, for example, a first conductivity-type (Al_{y}Ga_{1-y})ₓIn₁₋ₓP (0.4≤x≤0.6, 0.6≤y≤1.0) first cladding layer 13 of, e.g., 1.0 µm, a non-doped (Al_{y}Ga_{1-y})ₓIn₁₋ₓP (0.4≤x≤0.6, 0≤y≤0.5) active layer 14, a second conductivity-type (Al_{y}Ga_{1-y})ₓIn₁₋ₓP (0.4≤x≤0.6, 0.6≤y≤1.0) second cladding layer 15 of, e.g., 1.0 µm, a second conductivity-type GaₓIn₁₋ₓP (0.5≤x≤1.0) intermediate layer (not shown) of, e.g., 0.1 µm, and a second conductivity-type GaP window layer 16 are sequentially grown on the etching stop layer 12. At this point, from the first cladding layer 13 to the second cladding layer 15 is referred to as a double-hetero (DH) structure part (FIG. 1).

The film thicknesses exemplified above are just examples, and the film thickness is no more than a parameter to be changed according to the operating specifications of the device; therefore, the film thickness is not limited to the thickness described here. The case where both the first cladding layer 13 and the second cladding layer 15 have a thickness of 1.0 µm is exemplified, but rated current density of the micro-LED is smaller than that of a discrete LED with a larger size, and even with a thinner film thickness, a function as the cladding layer is not compromised.

As described later, the electrodes are formed as being in contact with the first cladding layer 13, thus it is suitable that the first cladding layer 13 has a thickness of 0.6 µm or more, considering metal diffusion during ohmic contact formation. A greater thickness than this is preferable and any greater thickness can be selected.

When the second conductivity-type is p-type, an effective mass of a hole is large, allowing the second cladding layer 15 having a thickness of, for example, about even 0.2 µm to function in the same way as in a thickness of 1.0 µm. Therefore, a thickness of 0.2 µm or more is preferable, and any greater thickness can be selected.

Moreover, a concept includes that each layer is not a single composition layer, but has a layer of a plurality of compositions within a range of compositions shown in the example. Furthermore, a concept includes that levels of carrier concentrations are not uniform in each layer but the concentrations have a plurality of levels in each layer.

The active layer 14 may be composed of a single composition or may have a super-lattice structure where a plurality of barrier layers and active layers are alternatively stacked. Both have the same function and any one of the cases can be selected.

In the present invention, the GaP window layer 16 is required to have a thickness of 6 µm or more. The thickness thinner than this causes the crack of the micro-LED device during the LLO step described later which results in the decrease in yield. Moreover, any thickness can be selected as the upper limit of the thickness of the GaP window layer 16 as long as the thickness thereof is within a thickness range that is thinner than a short side length at device isolation described later.

Next, as shown in FIG. 2, the GaP window layer 16 is bonded to a transparent substrate 30, being a to-be-bonded substrate transparent to visible light and ultraviolet light, via a thermosetting bonding member 25. This bonding can be specifically performed as follows. Benzocyclobutene (BCB), for example, is spin-coated as the thermosetting bonding member 25 on the epitaxial wafer 20. The transparent substrate 30 (for example, sapphire substrate), being the to-be-bonded substrate, is then stacked facing each other and bonded by thermocompression. This produces an epitaxial-bonded substrate by bonding the epitaxial wafer and the transparent substrate 30 (sapphire substrate) via BCB. When BCB is coated by spin coating, a designed film thickness can be, for example, 0.6 µm.

Note that the transparent substrate 30, being the to-be-bonded substrate, is not limited to the sapphire substrate, and any material can be selected as long as being transparent to visible light and ultraviolet light and flatness are guaranteed. Quartz can be selected instead of sapphire.

In addition, the thermosetting bonding member 25 is not limited to BCB, any material that is suitable for a laser process described later, i.e., a material transparent to visible light and absorbing ultraviolet light can be selected. Other than BCB, silicone resin, epoxy resin, SOG (Spin On Glass, spin-on-glass), polyimide (PI, Polyimide), and amorphous fluororesin such as CYTOP (registered trademark) can be used.

Moreover, in addition to being applied in a layered shape, the thermosetting bonding member 25, such as BCB, can be patterned into an isolated island shape, a line shape, or other shapes, and a bonding step is then performed, and the same result can be obtained. Moreover, the thickness of the thermosetting bonding member 25 is not limited to 0.6 µm; even with the thinner thickness, the same effect can be obtained.

Then, as shown in FIG. 3, the GaAs substrate 11, being the starting substrate, is separated. The more specific description is as follows. The GaAs substrate can be separated and removed by wet etching with ammonia-hydrogen peroxide mixture (a mixed solution of ammonia and hydrogen peroxide). This exposes a GaInP first etching stop layer out of the etching stop layer 12. Then the etchant is switched to a hydrochloric acid-based etchant to selectively remove the GaInP first etching stop layer out of the etching stop layer 12, and then the GaAs second etching stop layer out of the etching stop layer 12 is exposed. Then, the etchant is switched to a peroxide sulfuric-based etchant (a mixed solution of sulfuric acid and hydrogen peroxide) to selectively remove the GaAs second etching stop layer, thereby exposing the first cladding layer 13. By performing the above treatments, an epitaxial bonded substrate that retains only the DH layer and the GaP window layer can be produced.

Next, as shown in FIG. 4, the epitaxial layer is isolated into the micro-LED devices having a quadrilateral shape with a short side length of 50 µm or less. In addition, the second cladding layer 15 or the GaP window layer 16 in a partial region of the micro-LED device is exposed. This device isolation processing step is preferably performed by forming a pattern using a photolithography method and by an ICP (inductively coupled plasma, Inductively Coupled Plasma) etching using chlorine gas and argon gas (device isolation groove 47 in FIG. 4). The ICP process can be performed twice; the step of exposing the BCB layer (thermosetting bonding member 25), and the step of exposing the second cladding layer 15 or the GaP window layer 16.

The size of the device isolation here can be, for example, 25 µm×50 µm but this is just an example, and the present invention exhibits a remarkable effect on the minute micro-LED device having a quadrilateral shape with a short side length of 50 µm or less. Moreover, the GaP window layer 16 preferably has a thickness less than or equal to the short side length of the device isolation (when the size of the micro-LED device by the above device isolation is 25 µm×50 µm, the thickness is 25 µm or less). The reason thereof is that, although the LLO step itself is possible even when the GaP window layer 16 has a thickness of more than 25 µm, the micro-LED device is likely to fall over after the LLO when the GaP window layer 16 has a thickness thicker than the short side length. Consequently, even when the yield due to the crack of the micro-LED device is improved, a risk in which a transfer yield is decreased due to the falling over of the micro-LED device. Therefore, it is suitable to maintain a height of the GaP window layer 16 at or below the short side length.

In FIG. 4, an example is provided where the second cladding layer 15 is exposed; however, this is not limited to the case where the second cladding layer 15 is exposed. It is sufficient for the active layer 14 to be at least separated, and the same effect can be obtained even when the GaP window layer 16, rather than the second cladding layer 15, is exposed.

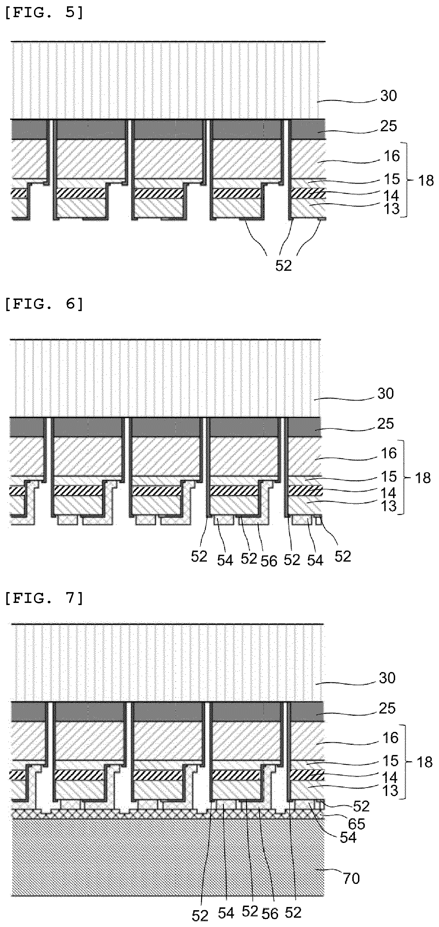

After the device isolation processing in FIG. 4, a protective film 52 can be formed as end face processing, as shown in FIG. 5. SiO₂ can be used as the protective film 52. In addition, the protective film 52 is not limited to SiO₂, but any material can be selected as long as the end face can be protected and the material has insulating properties. SiNₓ, titanium oxide, magnesium oxide, etc., can also be selected.

Following the formation of the protective film 52, as shown in FIG. 6, a first electrodes 54 in contact with the layer having the first conductivity-type and a second electrode 56 in contact with the layer having the second conductive-type are formed, and ohmic contact is then formed by performing heat treatment. For example, the first conductivity-type is designed as n-type, and the second conductivity-type is designed as p-type; metals containing Au and Si can be used for the electrode in contact with the n-type layer, and metals containing Au and Be can be used for the electrode in contact with the p-type layer.

The metals for the n-type electrode are not limited to Au and Si, and the same result can be obtained by using metals containing Au and Ge. Moreover, the metals for the p-type electrode are not limited to Au and Be, and the same result can be obtained by using metals containing Au and Zn.

After forming the ohmic contact, as shown in FIG. 7, the first electrode 54 and the second electrode 56 are adhered to a transfer substrate 70 via silicone resin 65. A quartz substrate is suitable for the transfer substrate 70. For example, as shown in FIG. 7, by using the transfer substrate 70 on which silicone resin 65 is applied to form a convex pattern, the transfer substrate 70 and the ohmic electrodes (the first electrode 54 and the second electrode 56) are faced each other, and the pressure is applied, then the ohmic electrodes portion (the first electrode 54 and the second electrode 56) can be adhered to the silicone resin 65.

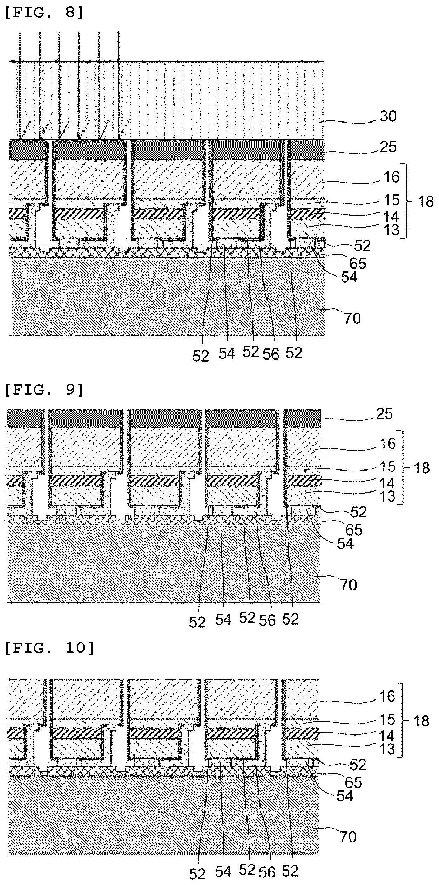

Next, as shown in FIG. 8, a laser (indicated by six single-headed arrows in FIG. 7) is irradiated from the transparent substrate 30 side. Then, the thermosetting bonding member 25 in contact with the transparent substrate 30 is sublimated by laser lift-off treatment, causing the micro-LED device isolated from the transparent substrate 30, thereby manufacturing the bonded wafer for a micro-LED (FIG. 9). In this way, for example, an excimer laser is irradiated from the transparent substrate 30 side, such as the sapphire substrate. Then, a layer of the thermosetting bonding member 25, such as BCB layer in contact with the transparent substrate 30, is sublimated by laser lift-off (LLO) treatment, causing the micro-LED device isolated from the transparent substrate 30.

After isolating the micro-LED device and the transparent substrate 30, such as the sapphire substrate, as shown in FIG. 10, the thermosetting bonding member 25, such as the BCB, remaining on the micro-LED device surface can be removed by ashing or plasma etching.

### EXAMPLE

Hereinafter, the present invention will be described in detail with reference to Example and Comparative Example. However, the present invention is not limited thereto.

### (Example and Comparative Example)

First, as shown in FIG. 1, an etching stop layer 12 was made on an n-type (first conductivity-type) GaAs substrate 11, being a starting substrate, after stacking an n-type GaAs buffer layer, followed by epitaxially growing an n-type GaInP first etching stop layer of 0.1 µm thickness, and an n-type GaAs second etching stop layer of 0.1 µm thickness. Moreover, an epitaxial wafer 20 was provided with a light emitting device structure 18 as an epitaxial functional layer, in which an n-type (Al_{y}Ga_{1-y})ₓIn₁₋ₓP (0.4≤x≤0.6, 0.6≤y≤1.0) first cladding layer 13 of 1.0 µm thickness, a non-doped (Al_{y}Ga_{1-y})ₓIn₁₋ₓP (0.4≤x≤0.6, 0≤y≤0.5) active layer 14, a p-type (Al_{y}Ga_{1-y})ₓIn₁₋ₓP (0.4≤x≤0.6, 0.6≤y≤1.0) second cladding layer 15 of 1.0 µm thickness, a p-type GaₓIn₁₋ₓP (0.5≤x≤1.0) intermediate layer (not shown) of 0.1 µm thickness, and a p-type GaP window layer 16 were sequentially grown (FIG. 1). At this point, the thickness of the GaP window layer 16 was varied in a range of 2 to 5 µm (Comparative Example) and 6 to 15 µm (Example).

Then, as shown in FIG. 2, benzocyclobutene (BCB) was spin-coated as a thermosetting bonding member 25 on the epitaxial wafer 20 (on the light emitting device structure 18). A sapphire wafer, being a transparent substrate 30, was then stacked facing each other and bonded by thermocompression, thereby bonding the epitaxial wafer to the sapphire substrate via BCB. When BCB was coated by spin coating, a designed film thickness was set to 0.6 µm.

Then, as shown in FIG. 3, the GaAs substrate 11, being the starting substrate, and the etching stop layer 12 were removed by wet etching to produce an epitaxial bonded substrate.

Next, as shown in FIG. 4, a pattern was formed using a photolithography method, followed by an ICP using chlorine gas and argon gas to perform device isolation processing of 50×100 µm (device isolation groove 47). The ICP processing was performed twice; the step of exposing the BCB layer 25, and the step of exposing the second cladding layer 15.

After the device isolation processing, a SiO₂ protective film 52 was formed as end face processing, as shown in FIG. 5.

Following the formation of the protective film 52, as shown in FIG. 6, a first electrode 54 and a second electrode 56 in contact with an n-type layer and a p-type layer were formed, respectively, and ohmic contact was then formed by performing heat treatment.

After forming the ohmic contact, as shown in FIG. 7, a transfer substrate 70 made of quartz, on which silicone resin 65 was applied to form a convex pattern, and ohmic electrodes (the first electrode 54 and the second electrode 56) were faced each other and pressure was applied to adhere the ohmic electrodes portion (the first electrode 54 and the second electrode 56) to the silicone resin 65.

Next, as shown in FIG. 8, an excimer laser was irradiated from a side of the transparent substrate 30 made of sapphire, and the BCB layer portion in contact with the sapphire substrate was sublimated by laser lift-off (LLO) treatment, causing the sapphire substrate and micro-LED dice isolated (FIG. 9). Furthermore, BCB was removed, as shown in FIG. 10.

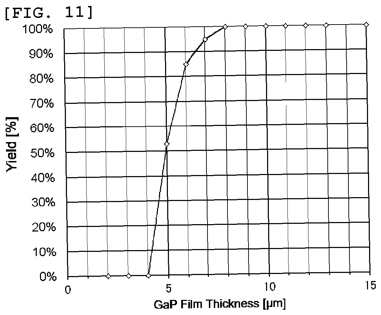

FIG. 11 shows the results of an investigation for yields of each wafer in which the Gap window layers 16 have different thicknesses. As shown in FIG. 11, when the GaP window layer 16 had a thickness of 4 µm or less (Comparative Example), all micro-LED devices were cracked and the yields thereof were 0. When the thickness of the GaP window layer 16 was 5 µm (Comparative Example), a good yield rate was improved but still insufficient. When the thickness of the GaP window layer 16 was 6 µm (Example), the good yield rate reached 80% or higher, and when the thickness of the GaP window layer 16 was 8 µm or higher (Example), cracking was eliminated, resulting in a 100% yield.

The present description includes the following embodiments.
[1]: A method for manufacturing a bonded wafer for a micro-LED, the method comprising the steps of:
   epitaxially growing an AlGaInP-based first cladding layer having a first conductivity-type, an AlGaInP-based non-doped active layer, and an AlGaInP-based second cladding layer having a second conductivity-type on a GaAs substrate to form an epitaxial layer;
   growing a GaP window layer on the second cladding layer;
   bonding the GaP window layer to a transparent substrate, being a to-be-bonded substrate transparent to visible light and ultraviolet light, via a thermosetting bonding member;
   separating the GaAs substrate;
   isolating the epitaxial layer into micro-LED devices each having a quadrilateral shape with a short side length of 50 µm or less;
   exposing the second cladding layer or the GaP window layer in a partial region of the micro-LED device;
   forming a first electrode in contact with a layer having the first conductivity-type and a second electrode in contact with a layer having the second conductivity-type, and performing heat treatment to form an ohmic contact;
   adhering the first electrode and the second electrode to a transfer substrate via silicone resin; and
   irradiating a laser from the transparent substrate side and sublimating the thermosetting bonding member in contact with the transparent substrate through laser lift-off treatment to isolate the micro-LED device from the transparent substrate, wherein
   the GaP window layer has a thickness of 6 µm or more.
[2]: The method for manufacturing a bonded wafer for a micro-LED according to the above [1], wherein
   the thermosetting bonding member is at least any of benzocyclobutene, silicone resin, epoxy resin, SOG, polyimide, and amorphous fluororesin.
[3]: The method for manufacturing a bonded wafer for a micro-LED according to the above [1] or [2], wherein
   the transparent substrate is a sapphire substrate or a quartz substrate.
[4]: The method for manufacturing a bonded wafer for a micro-LED according to the above [1], [2] or [3], wherein
   a method in the step of isolating the epitaxial layer into the micro-LED devices involves forming a pattern by a photolithography method, followed by an ICP etching using chlorine gas and argon gas.
[5]: The method for manufacturing a bonded wafer for a micro-LED according to the above [1], [2], [3], or [4], wherein
   the transfer substrate is a quartz substrate.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a bonded wafer for a micro-LED, the method comprising the steps of:
epitaxially growing an AlGaInP-based first cladding layer having a first conductivity-type, an AlGaInP-based non-doped active layer, and an AlGaInP-based second cladding layer having a second conductivity-type on a GaAs substrate to form an epitaxial layer;
growing a GaP window layer on the second cladding layer;
bonding the GaP window layer to a transparent substrate, being a to-be-bonded substrate transparent to visible light and ultraviolet light, via a thermosetting bonding member;
separating the GaAs substrate;
isolating the epitaxial layer into micro-LED devices each having a quadrilateral shape with a short side length of 50 µm or less;
exposing the second cladding layer or the GaP window layer in a partial region of the micro-LED device;
forming a first electrode in contact with a layer having the first conductivity-type and a second electrode in contact with a layer having the second conductivity-type, and performing heat treatment to form an ohmic contact;
adhering the first electrode and the second electrode to a transfer substrate via silicone resin; and
irradiating a laser from the transparent substrate side and sublimating the thermosetting bonding member in contact with the transparent substrate through laser lift-off treatment to isolate the micro-LED device from the transparent substrate, wherein
the GaP window layer has a thickness of 6 µm or more.

2. The method for manufacturing a bonded wafer for a micro-LED according to claim 1, wherein
the thermosetting bonding member is at least any of benzocyclobutene, silicone resin, epoxy resin, SOG, polyimide, and amorphous fluororesin.

3. The method for manufacturing a bonded wafer for a micro-LED according to claim 1 or 2, wherein
the transparent substrate is a sapphire substrate or a quartz substrate.

4. The method for manufacturing a bonded wafer for a micro-LED according to claim 1 or 2, wherein
a method in the step of isolating the epitaxial layer into the micro-LED devices involves forming a pattern by a photolithography method, followed by an ICP etching using chlorine gas and argon gas.

5. The method for manufacturing a bonded wafer for a micro-LED according to claim 1 or 2, wherein
the transfer substrate is a quartz substrate.
